# EUROPEAN PATENT APPLICATION

(11) **EP 1 890 330 A1**
(43) Date of publication of application: **20.02.2008**
(21) Application number: 06730643.1
(22) Date of filing: 30.03.2006
(51) Int. Cl.: H01L 23/36, H05K 7/20

(54) **HEAT SINK AND METHOD OF MANUFACTURING THE SAME**

(30) Priority: 30.03.2005 JP 2005099825
(71) Applicant: Jisouken Co., Ltd., Minato-ku Tokyo, 1060044 (JP)
(72) Inventor: HONMA, Mitsuo, Urayasu-shi, Chiba 2790026 (JP)
(74) Representative: Green, Mark Charles
(86) International application number: PCT/JP2006/306695
(87) International publication number: WO 2006/106840

(57) **Abstract**

The invention seeks to provide a heat sink capable of sufficiently lessening the mounting dimensions of coil-shaped heat exchanging fin to offer a wide versatility and a suitable method for manufacturing the heat sink.

The heat sink according to the invention comprises a heat exchanging substrate 1 made by forming material having high thermal conductivity into a cylindrical shape, and a heat exchanging fin 2 having coil elements, which is formed by winding a metal wire having high thermal conductivity into a coil and flattening the coil-shaped metal wire in whole with bringing the coil elements in contact with the adjacent ones in their mutually displaced state. The coil fin is secured on the outer surface of the heat exchanging substrate in their wound state.

## Description

### TECHNICAL FIELD

This invention belongs to the technical field of a heat sink used for cooling semiconductor elements as well as for other heat exchange applications.

There has been emergence of a heat sink using a heat exchanging fin formed by winding a metal wire having excellent heat conductance into a coil shape. The heat exchanging fin has the advantage of being able to ensure a heat exchanging area in proportion as its relatively narrow mounting dimensions in which the heat sink is incorporated.

As one example of a conventional method for manufacturing the heat sink using the coil-shaped heat exchanging fin, the following method has been known so far.

"Patent Literature 1" discloses a heat sink formed by joining heat fin formed in a coil spring to a flat heat exchanging plate having high thermal conductivity by soldering or laser welding.

[Patent Literature] Japanese Unexamined Patent Publication HEI 6-275746

### DISCLOSURE OF THE INVENTION

### PROBLEMS TO BE SOLVED BY THE INVENTION

The heat sink disclosed in the aforesaid "Patent Literature 1" suffers from the disadvantage that the mounting dimensions cannot sufficiently be lessened due to a large space formed in the axial center portion of the heat exchanging fin.

This invention is made to eliminate the drawbacks suffered by the conventional heat sink and seeks to provide a heat sink capable of sufficiently lessening the mounting dimensions of coil-shaped heat exchanging fin to offer a wide versatility and a suitable method for manufacturing the heat sink.

### MEANS OF SOLVING THE PROBLEMS

To solve the problems as described above according to the present invention, there is provided the following means.

That is, according to the present invention, there is provided a heat sink comprising a heat exchanging substrate made by forming material having high thermal conductivity into a cylindrical shape, and a heat exchanging fin having coil elements, which is formed by winding a metal wire having high thermal conductivity into a coil and flattening the coil-shaped metal wire in whole with bringing the coil elements in contact with the adjacent ones in their mutually displaced state. The coil fin is secured on the outer surface of the heat exchanging substrate in their wound state.

The flattening of the heat exchanging fin eliminates a large space in the axial center portion of the heat sink without reducing a heat exchanging area, so as to swiftly radiate heat through coherent parts between the adjacent coil elements. In addition, the inner space of the heat exchanging substrate formed in a cylindrical shape can be used for a great range of applications.

Further, the aforementioned heat sink according to the invention is featured in that the heat exchanging substrate is provided in its outer peripheral surface with attaching portions for fitting the inner part of the heat exchanging fin thereinto.

According to the structure as mentioned above, the heat exchanging fin can be secured in position within the attaching portions in the heat exchanging substrate. The attaching portion termed herein means a groove formed in the outer peripheral surface of the heat exchanging substrate or a space formed between protrusions on the outer peripheral surface of the heat exchanging substrate so as to fit the heat exchanging fin thereinto.

Further, the aforementioned heat sink according to the invention is featured in which the heat exchanging fin is continuously formed in a spiral manner relative to the axis line of the heat exchanging substrate.

The structure described above serves to form a common interface for heat exchange on the heat exchanging fin.

Further, the aforementioned heat sink according to the invention is featured in which the heat exchanging fin is divided into rings aligned orthogonal to the axis line of the heat exchanging substrate.

The structure described above serves to form divided interfaces for heat exchange on the heat exchanging fin.

Further, the invention with respect to any of the heat sinks described above is featured in that the heat exchanging substrate is formed by placing ring-shaped washers one on top of the other along the axis with the heat exchanging fin interposed fixedly between the washers.

The structure described above fulfills the heat sink having the washers and heat exchanging fins superimposed in a sandwich state.

Further, the invention with respect to any of the heat sinks described above is featured in that the heat exchanging fin has its outer periphery partially cut off to form a radiation accelerating portion for expediting convection of heat exchange fluid.

The structure described above functions to expand a flow passage for the heat exchange fluid in contact with the heat exchanging fin.

Further, the invention with respect to any of the heat sinks described above is featured in that the heat exchanging fin is cut off from its outer periphery to its inner periphery to form a convection expediting path for expediting convection of heat exchange fluid.

The structure described above functions to expand a flow passage for the heat exchange fluid in contact with the heat exchanging fins.

The present invention further provides a heat sink comprising a heat exchanging substrate made by forming material having high thermal conductivity into a flat plate shape, and a heat exchanging fin having coil elements, which is formed by winding a metal wire having high thermal conductivity into a coil and flattening the coil-shaped metal wire in whole with bringing the coil elements in contact with the adjacent ones in their mutually displaced state. The coil fin is secured on the outer surface of the heat exchanging substrate in their wound state.

The present invention further provides a heat sink comprising a spirally wound heat exchanging fin having coil elements formed by winding a metal wire having high thermal conductivity into a coil and flattening the coil-shaped metal wire in whole with bringing the coil elements in contact with the adjacent ones in their mutually displaced state.

The flattening of the heat exchanging fin eliminates a large space in the axial center portion of the heat sink without reducing a heat exchanging area, so as to swiftly radiate heat through coherent parts between the adj acent coil elements. Moreover, since a larger number of heat exchanging fins per unit area can be mounted, the heat sink having a large surface area can be obtained.

To solve the problems as described above according to the present invention, there is provided the following method for manufacturing a heat sink.

That is, according to the present invention, there is provided a method for manufacturing a heat sink, which comprises the steps of making a heat exchanging fin formed in a long strap shape by winding a metal wire having high thermal conductivity into a coil and flattening the coil-shaped metal wire in whole with bringing the coil elements in contact with the adjacent ones in their mutually displaced state, and continuously winding the strap-like heat exchanging fin around the outer periphery of a heat exchanging substrate made by forming material having high thermal conductivity into a cylindrical shape.

According to the method described above, the strap-like heat exchanging fin can be wound while being supplied continuously.

The present invention further provides a method for manufacturing a heat sink, which comprises the steps of making a heat exchanging fin formed in a long strap shape by winding a metal wire having high thermal conductivity into a coil and flattening the coil-shaped metal wire in whole with bringing the coil elements in contact with the adjacent ones in their mutually displaced state, and winding the heat exchanging fin around the outer periphery of a heat exchanging substrate made by forming material having high thermal conductivity into a cylindrical shape, while supplying the strap-like heat exchanging fin to the heat exchanging substrate being rotated.

According to the method described above, the strap-like heat exchanging fin can be wound while being supplied continuously to the rotating heat exchanging substrate.

The present invention further provides a method for manufacturing a heat sink, which comprises the steps of making a heat exchanging fin formed in a long strap shape by winding a metal wire having high thermal conductivity into a coil and flattening the coil-shaped metal wire in whole with bringing the coil elements in contact with the adjacent ones in their mutually displaced state, and securing the strap-like heat exchanging fin on a heat exchanging substrate made by forming material having high thermal conductivity into a flat plate while maintaining the strap-like heat exchanging fin in a spiral shape.

According to the method described above, the heat exchanging fin can be secured, being maintained in the spiral shape.

The present invention further provides a method for manufacturing a heat sink, which comprises the steps of making a heat exchanging fin formed in a long strap shape by winding a metal wire having high thermal conductivity into a coil, flattening the coil-shaped metal wire in whole with bringing the coil elements in contact with the adjacent ones in their mutually displaced state, and maintaining the strap-like heat exchanging fin in a spiral shape.

According to the method described above, the heat exchanging fin can be secured, being maintained in the spiral shape.

The present invention further provides the method for manufacturing a heat sink as described above, which is featured in that the heat exchanging fin has their inner peripheral portions inserted in attaching portions formed in the outer surface of the heat exchanging substrate, and the heat exchanging substrate and heat exchanging fin are mechanically bonded by applying pressure thereto in the axial direction of the heat exchanging substrate.

According to the method described above, the heat exchanging fin is secured at the positions defined by the attaching portions formed in the heat exchanging substrate by a mechanical process as mentioned above. The attaching portion termed herein means a groove formed in the outer peripheral surface of the heat exchanging substrate or a space formed between protrusions on the outer peripheral surface of the heat exchanging substrate so as to fit the heat exchanging fin thereinto.

### EFFECT OF THE INVENTION

The heat sink according to the present invention is featured by flattening the heat exchanging fin to eliminate a large space in the axial center portion of the heat sink without reducing a heat exchanging area, thus bringing about an effect of sufficiently narrowing dimensions for mounting the coil-shaped heat exchanging fin. Furthermore, effective heat radiation can be achieved by means of the heat exchanging fin having coherent parts among the adjacent coil elements in close contact with one another. Besides, the inner space of the heat exchanging substrate formed in a cylindrical shape can be used for a great range of applications.

### BRIEF DESCRIPTION OF THE DRAWINGS

[FIG 1] Perspective view showing a first embodiment of the best mode for practicing a heat sink and method for the same according to the present invention.
[FIG. 2] Front view of the heat sink.
[FIG. 3] Side view showing manufacturing processes carried out in the order of (A) and (B) subsequently to the process of FIG. 1.
[FIG. 4] Enlarged view showing around attaching portions of the heat sink.
[FIG. 5] Plan view showing the method for manufacturing a heat exchanging fin as an example.
[FIG. 6] Enlarged view showing the portion M in FIG 5.
[FIG 7] Side view showing the method for manufacturing the heat exchanging fin as an example.
[FIG. 8] Front view showing one example of the first embodiment of the heat sink in use.
[FIG 9] Side view showing another example of the first embodiment of the heat sink in use.
[FIG 10] Side view showing yet another example of the first embodiment of the heat sink in use.
[FIG 11] Front view showing the second preferred embodiment for practicing the heat sink and method for manufacturing the same according to the invention.
[FIG. 12] Front view showing the third preferred embodiment for practicing the heat sink and method for manufacturing the same according to the invention.
[FIG. 13] Side view of FIG 12.
[FIG 14] Front view showing the fourth preferred embodiment for practicing the heat sink and method for manufacturing the same according to the invention.
[FIG 15] Side view of FIG 14.
[FIG 16] Front view showing the fifth preferred embodiment for practicing the heat sink and method for manufacturing the same according to the invention.
[FIG. 17] Front view showing the sixth preferred embodiment for practicing the heat sink and method for manufacturing the same according to the invention.
[FIG. 18] Top view showing the sixth preferred embodiment according to the invention.
[FIG. 19] Top view showing the seventh preferred embodiment according to the invention.

### EXPLANATION OF REFERENCE MARKS

- 1: Heat exchanging substrate
- 10: Washer
- 11: Attaching portion
- 12: Hollow portion
- 13 and 14: Taper surface
- 2: Heat exchanging fin
- 2a and 2b: Coil element
- 2c: Contact portion
- 2h: Air gap
- 2d and 2d': Edge faces
- 2e: Radiation accelerating portion
- 2f: Convection expediting path
- 2g: Connector
- 2p: Radiation accelerating portion
- 21 and 22: Coils
- 211 and 221: Center portions
- 212 and 222: Flat surfaces
- 213 and 223: Side edges
- F: Applied force
- H: Housing
- P: Press die
- R: Thrust roller
- T: Heat exchanging object

The method for manufacturing the heat sink according to the present invention makes it possible to continuously supply and wind the heat exchanging fin on the heat exchanging substrate, so that the heat sink can be effectively mass-produced at a moderate cost of manufacture.

### BEST MODE FOR CARRYING OUT THE INVENTION

The best mode for carrying out the present invention relating to a heat sink and method for manufacturing the same will be described hereinafter with reference to the accompanying drawings.

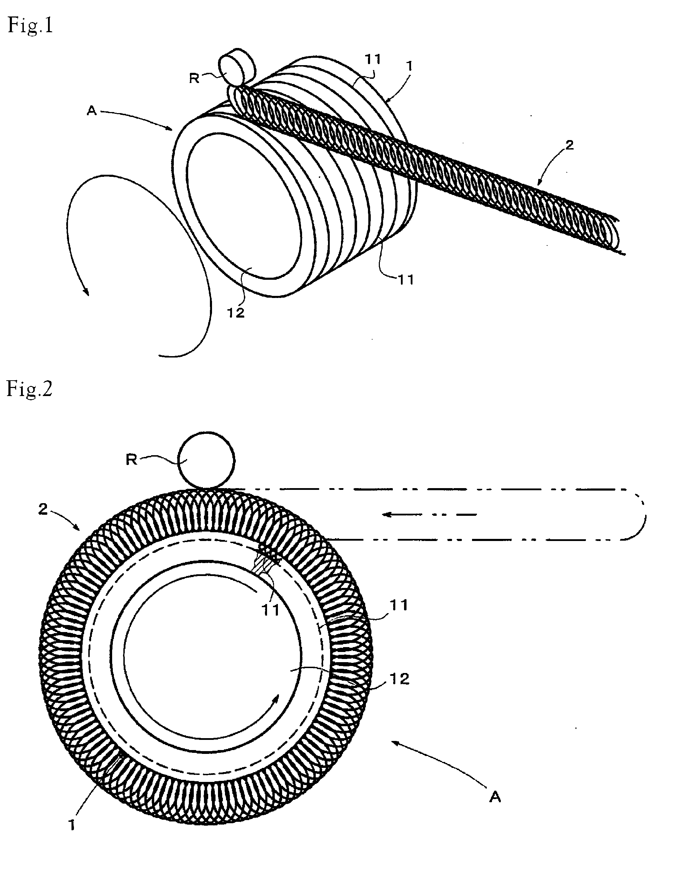

FIG 1 through FIG 10 illustrate the first embodiment of the best mode for carrying out the present invention relating to a heat sink and method for manufacturing the same.

The heat sink A in the first embodiment of the invention comprises a heat exchanging substrate 1 and a heat exchanging fin 2, as shown in FIG 1 through FIG 4.

The heat exchanging substrate 1 is formed of material having high thermal conductivity in a cylindrical shape. To be specific, the exchanging substrate is made of metallic material such as aluminum, copper, silver and gold or carbon material. The metallic material may optionally be an alloy comprising one or more selected from among nickel, magnesium, zinc and silicon. According to need, the substrate may be subjected to surface treatment to increase heat conductivity and corrosion resistance. In the outer surface of the heat exchanging substrate 1, an attaching portion 11 is formed in a spiral manner along the axis with respect to the heat exchanging substrate. The attaching portion 11 may be formed by a cutting work, die-casting or extrusion molding method. Within the heat exchanging substrate 11, a cylindrical hollow portion 12 is formed.

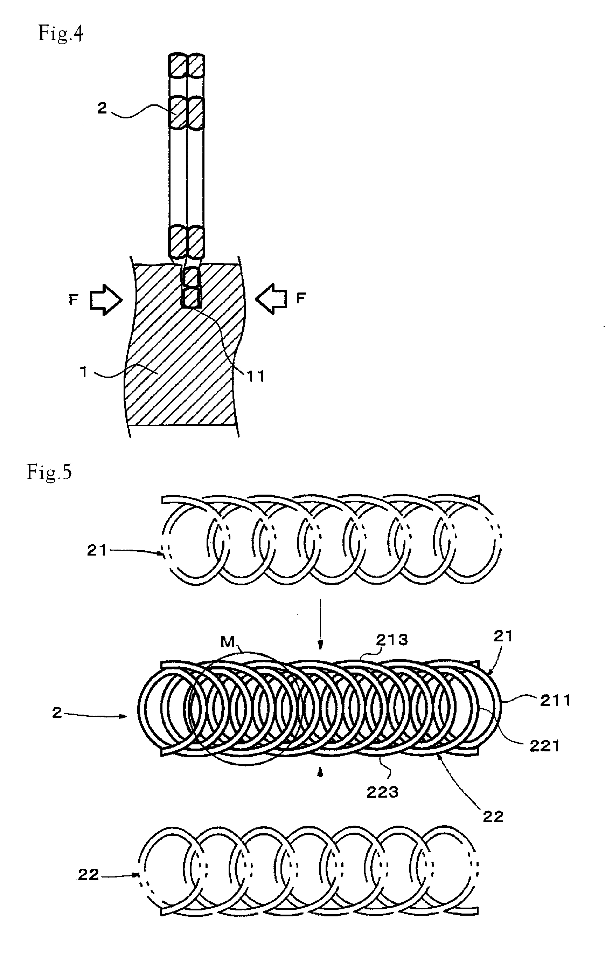

The heat exchanging fin 2 has coil elements formed by winding a metal wire of the same material as the heat exchanging substrate 1, which has excellent heat conductance into a coil shape. The coil elements come into contact with the adjacent ones and are made flat in whole in their mutually displaced state. The heat exchanging fin 2 is specifically formed by entwining two coils 21 and 22 having the same size and wound in the opposite direction at the same pitch, flattening the entwined coils into a flat strap and compressed flat in the superimposed integral state by applying pressure in the thickness direction, as shown in FIGS. 5-7. By applying the pressure to the entwined coils, the center portions 211 and 221 of the coils 21 and 22 are bent inward (toward the inside of the superimposed coils) and the outside of the superimposed coils 21 and 22 is made flat, thus to form flat surfaces 212 and 222 on the center portions 211 and 221. Thus, the heat exchanging fin 2 formed by the aforementioned method can be made thin as the outwardly protruding center portions 211 and 221 of the coils 12 and 22 are bent inward to reduce the thickness S of the flattened coils. Although the side edges 213 and 223 of the flattened coils have uneven surfaces due to the complexly intertwined metal wire elements, little flexibility of the entire coils in all directions can be assured.

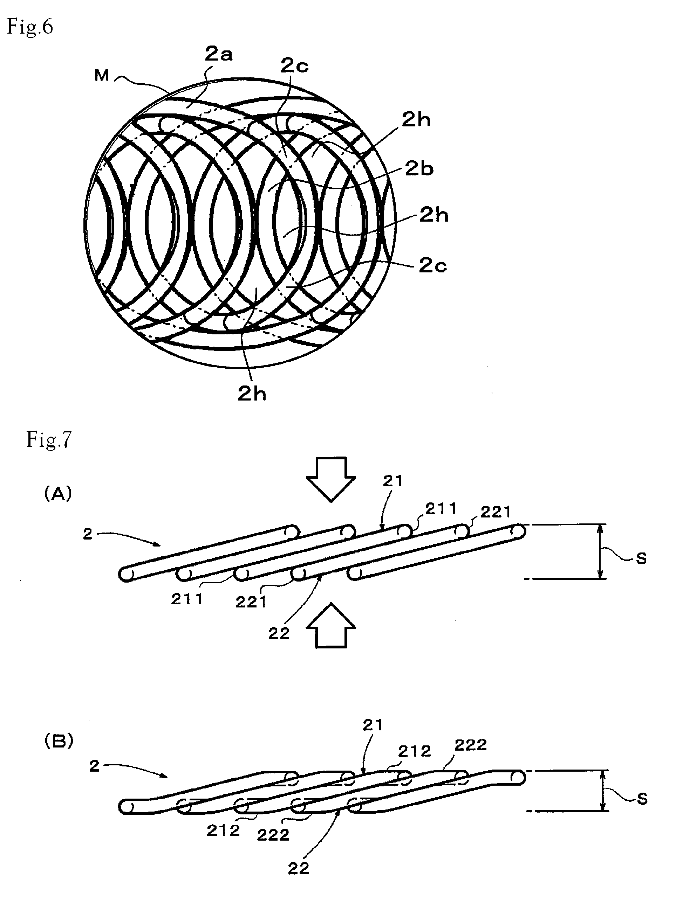

As shown in FIG 6, the coil elements of the heat exchanging fin 2, which are formed as a result of winding the metal wire into coils, are entirely flattened so as to bring the coil elements 2a and 2b in cross contact with one another in their mutually displaced state in the transverse and longitudinal directions, consequently to form air gaps 2h and contact portions 2c. That is, the coil elements 2a and 2b are mutually shifted to form a large number of air gaps 2h and contact portions 2c.

The adjacent coil elements 2a and 2b of the heat exchanging fin 2 are in mutually close contact with one another, consequently to enable efficient heat radiation of the entire heat exchanging fin through the contact portions 2c. The contact portions 2c formed by bringing the coil elements 2a and 2b in mutually close contact with one another may be inseparably bonded by a joining method such as soldering, solder plating, vibration welding and flash butt welding or an adhesive bonding method using adhesive so as to form effective thermal binding for reducing heat-transfer resistance. Thus, the contact portions 2c are fixedly bonded so as to steadily unite the coil elements 2a and 2b, consequently to improve mechanical stability of the entire heat exchanging fin 2 and increase the heat conductivity of the contact portions 2c.

The heat exchanging fin 2 includes spaces serving as air gaps 2h for allowing air current, thus to effectively dissipate heat in the substrate by blowing air into the air gaps with the aid of a cooling fan or the like.

The heat exchanging fin 2 has the metal wire coil elements 2a and 2b coming in mutually close contact with one another. The metal wire coil elements 2a and 2b are shifted in the transverse and longitudinal directions. The length by which the coil elements are shifted in the transverse direction is preferably determined to be 0.5 to 2 times the diameter of the metal wire. When the length by which the coil elements are shifted in the transverse direction is 2 or more times the diameter of the metal wire, the density of the coil elements may be low on the edge faces 2d and 2d'. To the contrary, when the length by which the coil elements are shifted in the transverse direction is less than 0.5 times the diameter of the metal wire, the coil elements are largely superimposed one on top, consequently to impair formability in flattening the heat exchanging fin by rolling. The length (n) by which the coil elements are shifted in the longitudinal direction is desirably determined to be 0.3 to 0.7 times, more preferably 0.4 to 0.6 times, as large as the longitudinal diameter of the coil elements 2a and 2b.

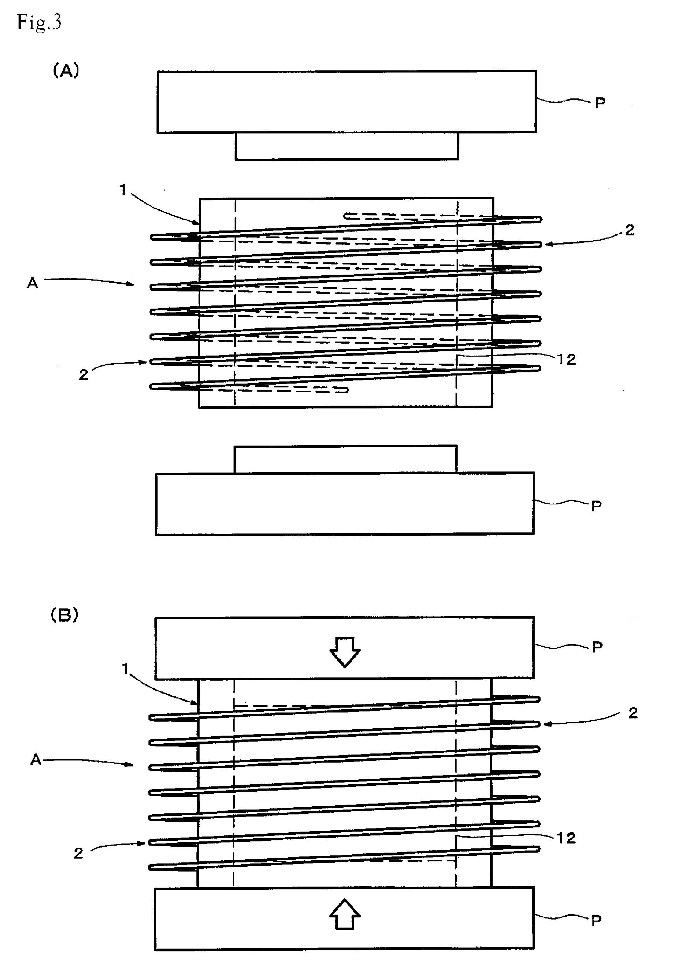

The heat sink A in the first embodiment is manufactured by supplying the heat exchanging fin 2 formed in a long strap shape onto the heat exchanging substrate 1 rotating around its axis, thus to continuously wind the heat exchanging fin 2 around the outer periphery of the heat exchanging substrate 1, as shown in FIG 1 and FIG 2. The heat exchanging fin 2 can be steadily fitted into the attaching portion 11 formed in the outer periphery of the heat exchanging substrate 1 by being forced thereinto by using a trust roller R mounted close to the heat exchanging substrate 1, so that the heat exchanging fin 2 fitted in the attaching portion 11 of the heat exchanging substrate 1 can be prevented from slipping sideways on the outer periphery of the heat exchanging substrate 1. Subsequently, the heat exchanging substrate 1 (attaching portion 11) is deformed by applying pressure thereto in the axial direction of the heat exchanging substrate 1 by using a press die as shown in FIG 3, thus to steadily fix the heat exchanging substrate 1 and heat exchanging fin 2 by calking with pressure F as shown in FIG 4.

According to the method for manufacturing the heat sink A in the first embodiment, the strap-like heat exchanging fin can be wound around the heat exchanging substrate 1 while being supplied continuously, so that the direction of supplying the heat exchanging fin 2 can be prevented from interfering with the pressure applied by the press die P, thereby to enable the heat sink to be effectively mass-produced at a moderate cost of manufacture.

The heat sink A made in the first embodiment of the invention has a function of eliminating a large space in the axial center portion of the heat sink due to the flattened heat exchanging fin 2 without reducing a heat exchanging area, thus bringing about an effect of sufficiently narrowing dimensions for mounting the coil-shaped heat exchanging fin. Although a compression force is caused on the inner periphery of the heat exchanging fin 2 wound around the heat exchanging substrate 1 while a pulling force is caused on the outer periphery of the heat exchanging fin, occurrence of distortion can be prevented due to flexibility of the heat exchanging fin 2, so that durability of the heat sink can remain intact. Specifically, since the coil-shaped metal wire becomes less dense at the outer periphery of the heat exchanging fin 2 due to the pulling force and, to the contrary, it increase its density at the inner periphery of the heat exchanging fin due to the compression force, high thermal conductivity can be especially obtained in dissipating heat from the heat exchanging substrate 1. Moreover, the heat exchanging fin 2 is wound continuously in a spiral around the heat exchanging substrate, uniform heat exchange can effectively be fulfilled throughout the entire heat exchanging substrate 1.

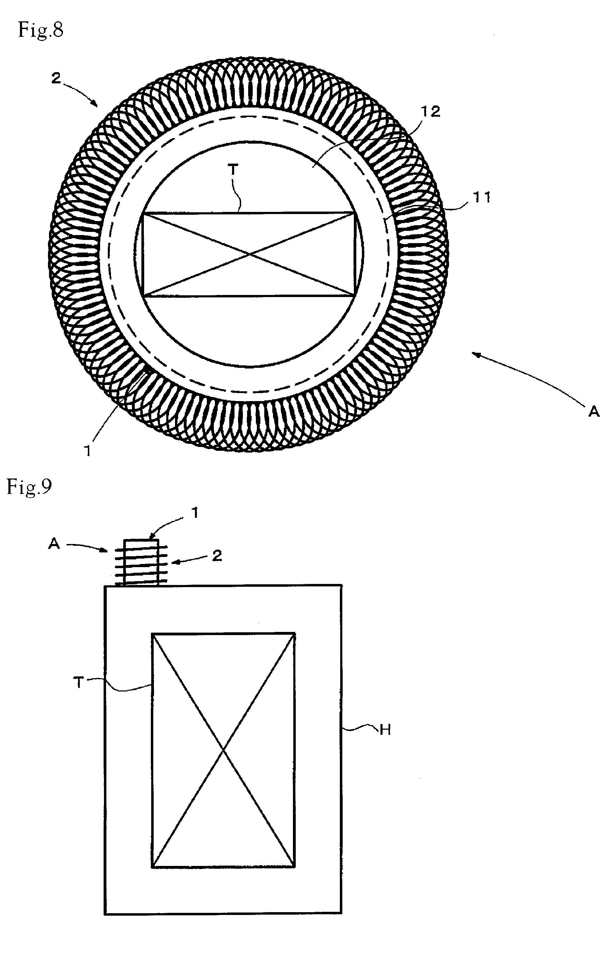

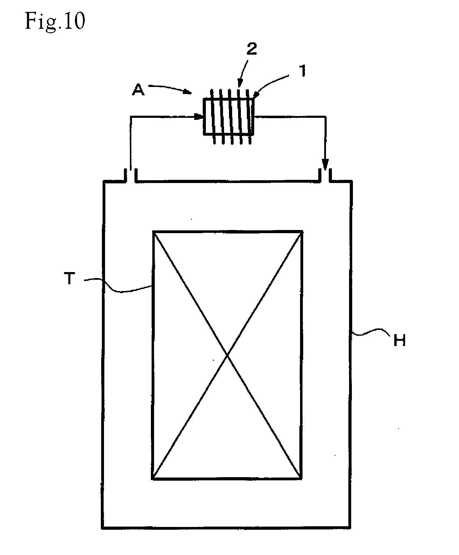

Since the hollow portion 12 in the heat exchanging substrate 1 has a wide array of uses, the heat sink can be used for a great range of applications. For example, an object T to be subjected to heat exchange such as a semiconductor device may be placed within the hollow portion 12 in the heat exchanging substrate 1, i.e. the heat exchanging substrate 1 can be used as a housing H for the object T (see FIG 8). As another example, the hollow portion 12 in the heat exchanging substrate 1 may be designed so as to pass therethrough the heat in the housing H for the object T to be subjected to heat exchange, so that the heat exchanging substrate 1 can be used as a cooling unit connected to the housing H (see FIG 10).

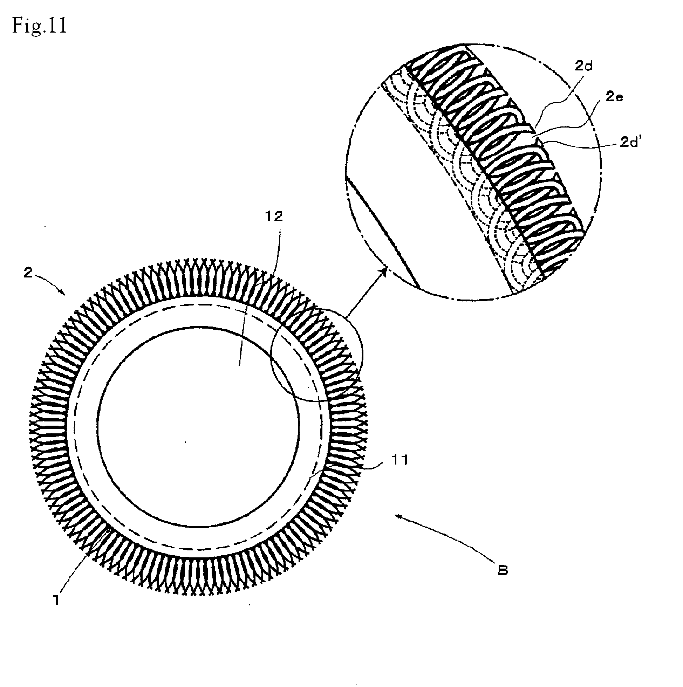

FIG 11 shows the second preferred embodiment for practicing the heat sink and method for manufacturing the same according to the invention.

Similarly to the heat sink A in the first embodiment, the heat sink B in the second embodiment basically comprises a heat exchanging fin having coil elements, which is formed by winding a metal wire having high thermal conductivity into a coil and flattening the coil-shaped metal wire in whole with bringing the coil elements in contact with the adjacent ones in their mutually displaced state, but the heat sink in this embodiment has the heat exchanging fin 2 with its outer periphery partially cut off to expose the edge face 2d of the metal wire, thus to form a radiation accelerating portion 2e for expediting convection of heat exchange fluid flowing between the edge faces 2d and 2d', as illustrated in the enlarged view of FIG. 11.

Thus, according to the heat sink B, heat exchange fluid such as air enters the radiation accelerating portion 2e formed by the cut in the edge face of the heat exchanging fin, to effectively cause convection of the heat exchange fluid passing through the gaps in the heat exchanging fin 2. Consequently, the flow passage can be expanded for the heat exchange fluid in contact with the heat exchanging fins, thus to heighten the performance of heat exchange.

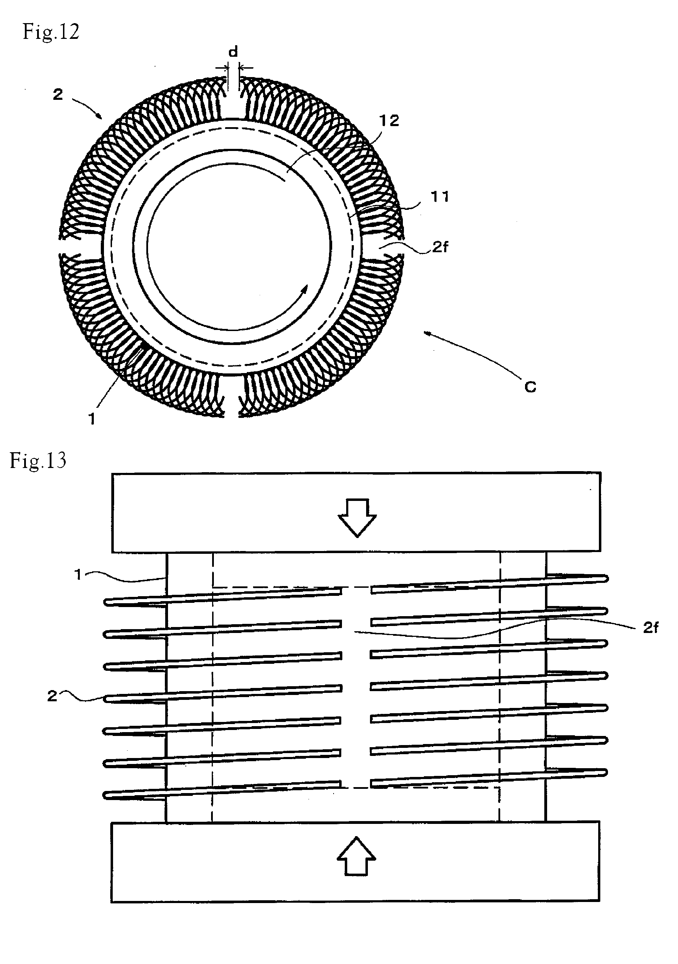

FIG 12 and FIG 13 illustrate the third preferred embodiment for practicing the heat sink and method for manufacturing the same according to the invention.

Similarly to the heat sink A in the first embodiment, the heat sink C in the second embodiment basically comprises a heat exchanging fin having coil elements, which is formed by winding a metal wire having high thermal conductivity into a coil and flattening the coil-shaped metal wire in whole with bringing the coil elements in contact with the adjacent ones in their mutually displaced state, but the heat sink in this embodiment has the heat exchanging fin 2 with its outer periphery partially cut off in a slit shape from its outer periphery to its inner periphery, thus to form a convection expediting path 2f for expediting convection of heat exchange fluid flowing along the side surface of the heat sink C.

Thus, according to the heat sink C, heat exchange fluid such as air occurs efficiently through the slit-like convection expediting path 2f and the gaps in the heat exchanging fin 2, so that the flow passage can be expanded for the heat exchange fluid in contact with the heat exchanging fin. Consequently, the flow passage can be expanded for the heat exchange fluid in contact with the heat exchanging fins, thus to heighten the performance of heat exchange.

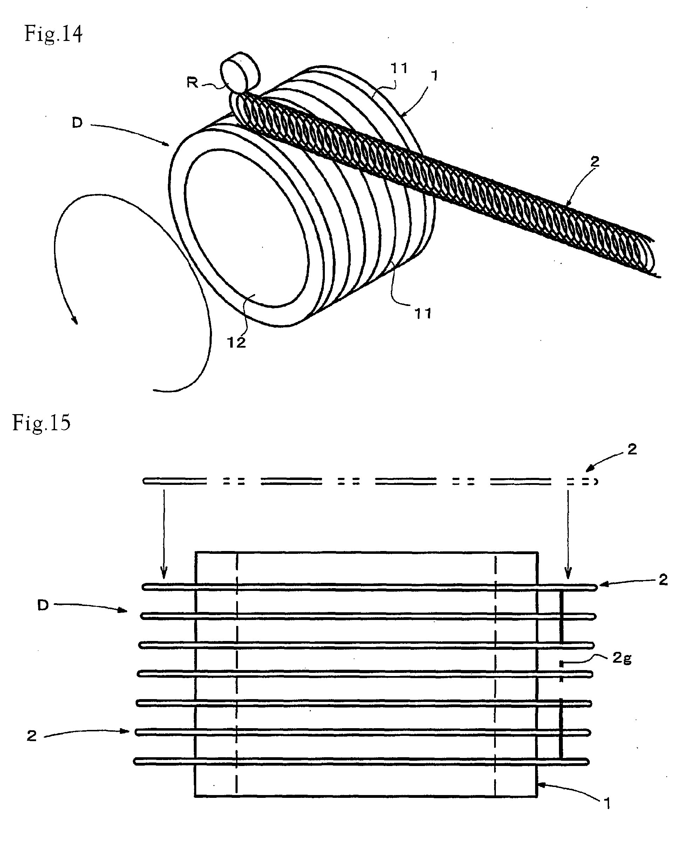

FIG 14 and FIG 15 illustrate the fourth preferred embodiment for practicing the heat sink and method for manufacturing the same according to the invention.

The heat sink D has the heat exchanging fin 2 divided into rings aligned orthogonal to the axis line of the heat exchanging substrate.

According to the heat sink D of the fourth embodiment, if the heat exchanging fin 2 is damaged even in part, it does not affect the other part of the heat exchanging fin 2, so that reliable heat exchange can be performed invariably.

To manufacture the heat sink D of the fourth embodiment, there may be adopted a method comprising the steps of making the heat exchanging fin formed by winding a metal wire having high thermal conductivity into a coil, flattening the coil-shaped metal wire in whole with bringing the coil elements in contact with the adjacent ones in their mutually displaced state, and winding the heat exchanging fin 2 around the heat exchanging substrate while maintaining the heat exchanging fin in the ring shape so as to be fitted into the heat exchanging substrate 1 in the axial direction. A plurality of ring-shaped heat exchanging fins 2 may be connected to one another with connectors 2b having high thermal conductivity in order to increase heat radiating performance of the entire heat sink.

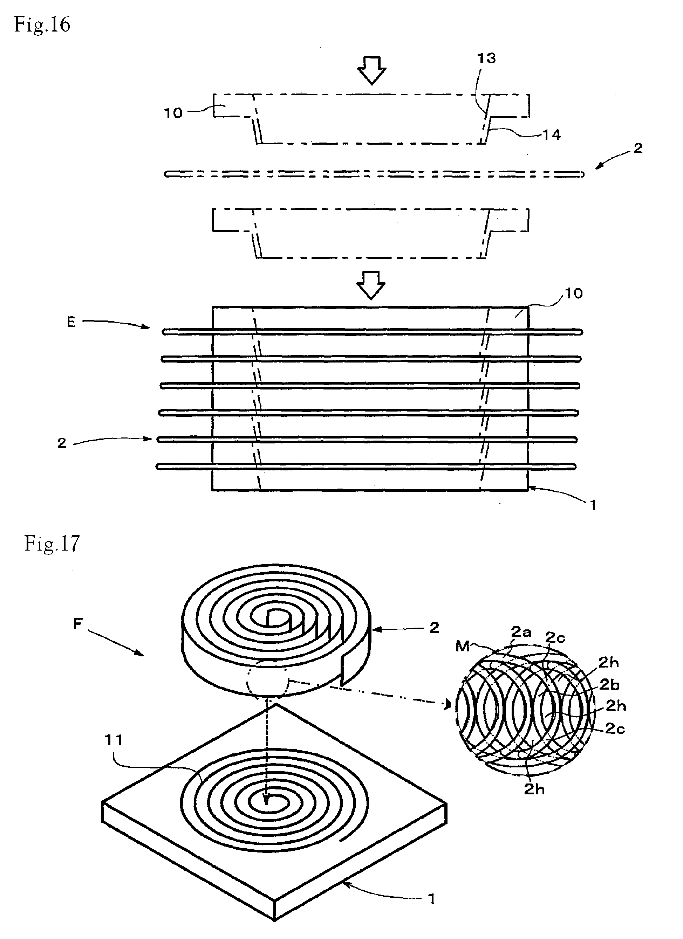

FIG 16 shows the fifth preferred embodiment for practicing the heat sink and method for manufacturing the same according to the invention.

The heat sink E in the fifth embodiment of the invention has the heat exchanging substrate 1 formed by placing ring-shaped washers 10 one on top of the other along the axis. The heat exchanging fin 2 having coil elements is formed by winding a metal wire having high thermal conductivity into a coil and flattening the coil-shaped metal wire in whole with bringing the coil elements in contact with the adjacent ones in their mutually displaced state. A plurality of heat exchanging fins 2 are interposed fixedly between the piled washers 10.
In manufacturing the heat sink E, the washers 10 and heat exchanging fins, which are alternately piled one on top of another as shown in FIG 16, may desirably be compressed by pressure.

The heat sink E in the fifth embodiment does not need a process of forming grooves for securing the heat exchanging fin 2 on the heat exchanging substrate 1 by cutting, so that the desired heat sink can be made efficiently.

The inner and outer peripheries of the ring-shaped washer 10 may be provided with taper surfaces 13 and 14, so that the washer can easily be coupled with the other washers, thus to be steadily united with the heat exchanging fins 2. Although the inner surface of the heat sink E is uneven due to the piled washers, a tube made of metal having high thermal conductivity may be inserted into the cylindrical heat sink E to make the inner surface of the heat sink E flat, as occasion demands, consequently to improve heat radiating performance of the heat sink.

FIG 17 shows the sixth preferred embodiment for practicing the heat sink and method for manufacturing the same according to the invention.

The heat sink G in the sixth embodiment is provided on the flat heat exchanging substrate 1 with a spiral attaching portion 11.

In the heat sink G in the sixth embodiment, the heat exchanging fin 2 having coil elements, which is formed in a long strap shape by winding a metal wire having high thermal conductivity into a coil and flattening the coil-shaped metal wire in whole with bringing the coil elements in contact with the adjacent ones in their mutually displaced state, is wound in a spiral so as to form the air gap 2h in the strap-like heat exchanging fin 2 and fitted into the attaching portion 11 of the heat exchanging substrate 1 with the shape maintained in the spiral.

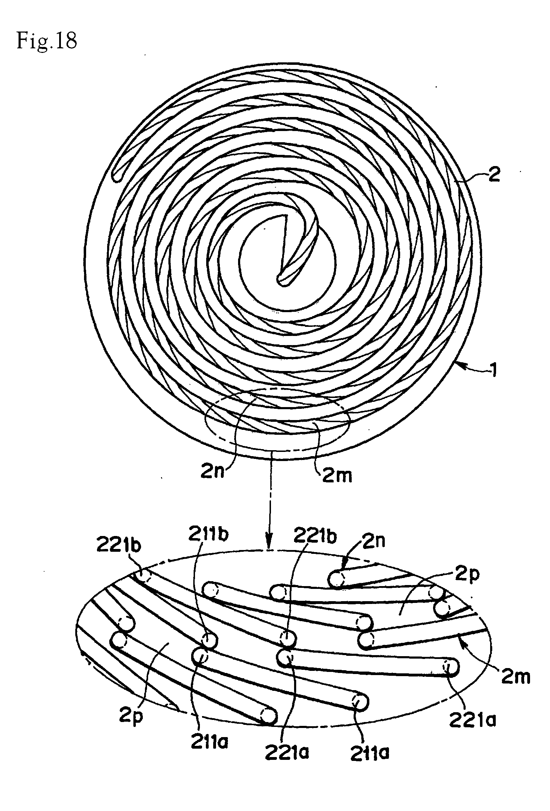

FIG 18 is a top view of the heat sink G The heat exchanging fin 2 is spirally wound in the longitudinal direction as shown in FIG 18 in the state of bringing adjacent coil elements 2m and 2n in mutual contact with one another. To be more specific, when the heat exchanging fin 2 is spirally wound in the longitudinal direction, the heat exchanging fin 2 intersects with each of the adjacent coil elements 2a and 2b. As a result, the center portions 211 a, 211 b, 221 a and 221 b of the heat exchanging fin 2 flattened into coils 2A and 2B assume their upcurved state in conformity with the spiral shape of the heat exchanging fin. Thus, the center portions 211a and 211b of the adjacent coil elements 2m and 2n of the heat exchanging fin 2 are in contact with each other, and similarly, the center portions 221a and 221b are in contact with each other. Thus, the adjacent coil elements 2m and 2n are in mutual contact with each other, consequently to heighten thermal conductivity between the coil elements 2m and 2n. In addition to heat conduction along the spiral heat exchanging fin 2, further heat conduction in the radial direction from the center of the heat exchanging fin is also expedited, so that smooth heat conduction throughout the heat exchanging fin 2 can be fulfilled.

Moreover, the heat exchanging fin 2 wound in a multiple spiral has a number of air gaps 2h, so that air flow can be made smooth from the center toward the outer periphery of the fin or inversely, from the outer periphery toward the center of the fin. Since the heat exchanging fin 2 wound in a multiple spiral has the center portions 211a, 211b, 221a and 221b curved in the radial direction, a radiation accelerating portion 2p serving as a gap for ventilating air is formed between the coil elements 2m and 2n elsewhere than the center portions 211a, 211b, 221a and 221b. Thus, the heat exchanging fin 2 has a large contact area with the air, serving as air ventilation holes, thereby to improve a ventilating effect. Further by blowing air into the air gaps in the heat exchanging fin 2 with the aid of a cooling fan or the like, the heat produced in the object to be cooled can be smoothly removed with the air passing through the air gaps 2h and radiation accelerating portion 2p in the heat exchanging fin 2.

Since the heat exchanging fin 2 is shaped in a spiral, numbers of heat exchanging fins may be formed per unit area, thus to obtain a large surface area serving as a heat sink. In spirally winding the heat exchanging fin 2 with the adjacent coil elements 2m and 2n in mutual contact with one another, winding of the heat exchanging fin can easily be carried out.

Although the spiral attaching portion 11 is disposed on the heat exchanging substrate 1 for mounting the heat exchanging fin 2 is mounted on the heat exchanging substrate in the aforementioned embodiments, the heat exchanging fin 2 may be attached directly to the flat heat exchanging substrate 1 by soldering or other joining method without using the attaching portion 11.

Although the heat exchanging fin 2 is wound in a spiral so as to bring the adjacent coil elements 2m and 2n in mutual contact with one another, the coil elements may be separated from one another. In this case, thermal conduction is performed along the spiral heat exchanging fin 2.

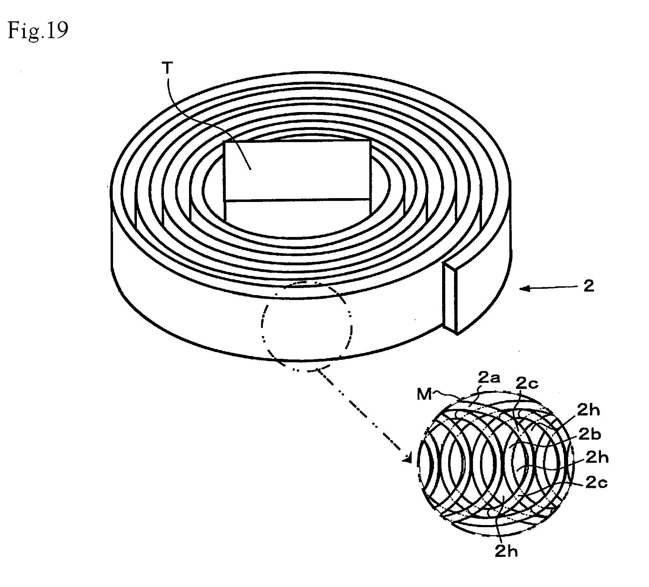

FIG 19 shows the seventh preferred embodiment for practicing the heat sink and method for manufacturing the same according to the invention.

In the heat sink J in the seventh embodiment as shown in FIG 19, the heat exchanging fin 2 having coil elements is formed in a long strap shape by winding a metal wire having high thermal conductivity into a coil and flattening the coil-shaped metal wire in whole with bringing the coil elements in contact with the adjacent ones in their mutually displaced state and maintained in a spiral shape. In the center portion of the spirally wound heat exchanging fin 2, there is formed a space for accommodating an object T to be subjected to heat exchange. The heat exchanging fin 2 is secured so as to be in contact with the object T.

The heat sink J of the seventh embodiment is formed like a strap and maintained in its spiral shape.

According to the heat sink J of the seventh embodiment, heat produced in the object T to be cooled can be smoothly transmitted to the entire heat exchanging fin 2 through the contact portions of the heat exchanging fin 2 wound in a spiral. Since the heat exchanging fin 2 has a sufficiently large contact surface with the heat exchange fluid such as air, thus to permit the heat exchange fluid to efficiently pass through the air gaps 2h in the heat exchanging fin 2, heat radiating performance can be improved to efficiently fulfill heat radiation from the object T to be cooled.

As well as the aforementioned embodiments, the heat exchanging substrate 1 and heat exchanging fin 2 may be fixed by soldering. That is, the method of integrally uniting the heat exchanging substrate 1 with the heat exchanging fin 2 by soldering is carried out by first placing a string-like solder material between the attaching portions 11 of the heat exchanging substrate 1 and then heating the overlapping heat exchanging substrate 1 and heat exchanging fin 2 to melt the solder material.

Molten solder material in soldering is restrained by the attaching portion 11 of the heat exchanging substrate 1, but transudes from the inner periphery to the outer periphery of the heat exchanging fin 2 having a complicatedly uneven structure by the capillary phenomenon. Therefore, the contact portion between the heat exchanging substrate 1 and the heat exchanging fin 2 become enlarged widely into a strip due to weld overlay of the solder material yielded in soldering, thus to increase the anchorage strength of the heat exchanging substrate 1 and heat exchanging fin 2 and improve thermal conduction from the heat exchanging substrate 1 to the heat exchanging fin 2.

The heat exchanging substrate 1 and heat exchanging fin 2 may be fixed with an adhesive having thermal conductivity. As the adhesive having thermal conductivity, there may be used an adhesive mixed with metallic powder such as of gold, silver and nickel, alumina, aluminum nitride, silicon nitride and/or carbon particles in addition to a binder such as of epoxide resin, silicon resin, acrylate resin and/or urethane resin.

The heat exchanging substrate 1 and heat exchanging fin 2 may be fixed by welding. As the welding method, flash welding or vibration welding (ultrasonic welding) is available.

When uniting the heat exchanging substrate 1 and the heat exchanging fin 2 by soldering, welding or using an adhesive, the attaching portion 11 is not indispensable for the heat exchanging substrate 1. The attaching portion 11 is formed like grooves in the aforementioned first embodiment, but, for example, alternative projections may be formed at a regular interval on the heat exchanging substrate 1 so as to place the heat exchanging fin 2 between the projections.

In manufacturing the heat sink in the aforementioned first embodiment, the cylindrical heat exchanging substrate 1 is rotated to wind the heat exchanging fin 2 therearound, but the process of winding the heat exchanging fin around the heat exchanging substrate should not be understood as being limited thereto. Instead, the heat exchanging fin 2 may be revolved around the stationary heat exchanging substrate 1 to be continuously wound therearound by way of example.

The heat exchanging substrate 1 may be formed in a rectangular cylinder.

### INDUSTRIAL APPLICABILITY

The heat sink according to the present invention is available to the whole field of technology relating to heat exchange.

## Claims

1. A heat sink comprising a heat exchanging substrate made by forming material having high thermal conductivity into a cylindrical shape, and a heat exchanging fin having coil elements formed by winding a metal wire having high thermal conductivity into a coil and flattening the coil-shaped metal wire in whole, said coil elements being in contact with the adjacent ones in their mutually displaced state, said coil fin being secured on the outer surface of said heat exchanging substrate in their wound state.

2. The heat sink set forth in Claim 1, wherein said heat exchanging substrate is provided in its outer peripheral surface with attaching portions for fitting the inner part of said heat exchanging fin thereinto.

3. The heat sink set forth in Claim 1 or Claim 2, wherein said heat exchanging fin is continuously formed in a spiral manner relative to the axis line of said heat exchanging substrate.

4. The heat sink set forth in Claim 1 or Claim 2, wherein said heat exchanging fin is divided into rings aligned orthogonal to the axis line of said heat exchanging substrate.

5. The heat sink set forth in Claim 4, wherein said heat exchanging substrate is formed by placing ring-shaped washers one on top of the other along the axis with said heat exchanging fin interposed fixedly between said washers.

6. The heat sink set forth in Claim 1 or Claim 2, wherein said heat exchanging fin has its outer periphery partially cut off to form a radiation accelerating portion for expediting air convection of heat exchange fluid.

7. The heat sink set forth in Claim 3, wherein said heat exchanging fin has its outer periphery partially cut off to form a radiation accelerating portion for expediting air convection of heat exchange fluid.

8. The heat sink set forth in Claim 4, wherein said heat exchanging fin has its outer periphery partially cut off to form a radiation accelerating portion for expediting air convection of heat exchange fluid.

9. The heat sink set forth in Claim 5, wherein said heat exchanging fin has its outer periphery partially cut off to form a radiation accelerating portion for expediting air convection of heat exchange fluid.

10. The heat sink set forth in Claim 1 or Claim 2, wherein said heat exchanging fin is cut off from its outer periphery to its inner periphery to form a convection expediting path for expediting air convection of heat exchange fluid.

11. The heat sink set forth in Claim 3, wherein said heat exchanging fin is cut off from its outer periphery to its inner periphery to form a convection expediting path for expediting air convection of heat exchange fluid.

12. The heat sink set forth in Claim 4, wherein said heat exchanging fin is cut off from its outer periphery to its inner periphery to form a convection expediting path for expediting air convection of heat exchange fluid.

13. The heat sink set forth in Claim 5, wherein said heat exchanging fin is cut off from its outer periphery to its inner periphery to form a convection expediting path for expediting air convection of heat exchange fluid.

14. The heat sink set forth in Claim 6, wherein said heat exchanging fin is cut off from its outer periphery to its inner periphery to form a convection expediting path for expediting air convection of heat exchange fluid.

15. The heat sink set forth in Claim 7, wherein said heat exchanging fin is cut off from its outer periphery to its inner periphery to form a convection expediting path for expediting air convection of heat exchange fluid.

16. The heat sink set forth in Claim 8, wherein said heat exchanging fin is cut off from its outer periphery to its inner periphery to form a convection expediting path for expediting air convection of heat exchange fluid.

17. The heat sink set forth in Claim 9, wherein said heat exchanging fin is cut off from its outer periphery to its inner periphery to form a convection expediting path for expediting air convection of heat exchange fluid.

18. A heat sink a heat exchanging substrate made by forming material having high thermal conductivity into a flat plate shape, and a heat exchanging fin having coil elements formed by winding a metal wire having high thermal conductivity into a coil and flattening the coil-shaped metal wire in whole, said coil elements being in contact with the adjacent ones in their mutually displaced state, said coil fin being secured on the outer surface of said heat exchanging substrate in their wound state.

19. A heat sink comprising a spirally wound heat exchanging fin having coil elements formed by winding metal wire having high thermal conductivity into a coil and flattening the coil-shaped metal wire in whole with bringing said coil elements in contact with the adjacent ones in their mutually displaced state.

20. A method for manufacturing a heat sink, comprising the steps of making a heat exchanging fin formed in a long strap shape by winding a metal wire having high thermal conductivity into a coil and flattening the coil-shaped metal wire in whole with bringing said coil elements in contact with the adjacent ones in their mutually displaced state, and continuously winding said strap-like heat exchanging fin around the outer periphery of a heat exchanging substrate made by forming material having high thermal conductivity into a cylindrical shape.

21. A method for manufacturing a heat sink, comprising the steps of making a heat exchanging fin formed in a long strap shape by winding a metal wire having high thermal conductivity into a coil and flattening the coil-shaped metal wire in whole with bringing said coil elements in contact with the adjacent ones in their mutually displaced state, and winding said heat exchanging fin around the outer periphery of a heat exchanging substrate made by forming material having high thermal conductivity into a cylindrical shape, while supplying said strap-like heat exchanging fin to said heat exchanging substrate being rotated.

22. A method for manufacturing a heat sink claimed in Claim 20 or Claim 21, wherein said heat exchanging fin has their inner peripheral portions inserted in attaching portions formed in the outer surface of said heat exchanging substrate, and said heat exchanging substrate and heat exchanging fin are mechanically bonded by applying pressure thereto in the axial direction of said heat exchanging substrate.

23. A method for manufacturing a heat sink, comprising the steps of making a heat exchanging fin formed in a long strap shape by winding a metal wire having high thermal conductivity into a coil and flattening the coil-shaped metal wire in whole with bringing said coil elements in contact with the adjacent ones in their mutually displaced state, and securing said strap-like heat exchanging fin on a heat exchanging substrate made by forming material having high thermal conductivity into a flat plate while maintaining said strap-like heat exchanging fin in a spiral shape.

24. A method for manufacturing a heat sink, comprising the steps of making a heat exchanging fin formed in a long strap shape by winding a metal wire having high thermal conductivity into a coil, flattening the coil-shaped metal wire in whole with bringing said coil elements in contact with the adjacent ones in their mutually displaced state, and maintaining said strap-like heat exchanging fin in a spiral shape.
